# EUROPEAN PATENT SPECIFICATION

(11) **EP 3 347 990 B1**
(45) Date of publication and mention of the grant of the patent: **10.07.2019**
(21) Application number: 16770414.7
(22) Date of filing: 09.09.2016
(51) Int. Cl.: H03K 19/177, H03K 19/173

(54) **CASCADED LOOKUP-TABLE (LUT) CARRY LOGIC CIRCUIT**
SCHALTUNG MIT KASKADIERTER LOOKUP-TABLE (LUT) UND CARRY LOGIC
CIRCUIT AVEC LOOKUP-TABLE (LUT) ET CARRY LOGIC CASCADÉS

(30) Priority: 11.09.2015 US 201514852164; 11.09.2015 US 201514851577
(43) Date of publication of application: 18.07.2018
(73) Proprietor: Xilinx, Inc., San Jose, California 95124 (US)
(72) Inventor: GAIDE, Brian, C., San Jose, CA 95124 (US); YOUNG, Steven, P., San Jose, CA 95124 (US); KAVIANI, Alireza S., San Jose, CA 95124 (US)
(74) Representative: McGlashan, Graham Stewart
(86) International application number: PCT/US2016/051052
(87) International publication number: WO 2017/044812

(56) References cited:
- WO-A1-98/51013
- US-A- 5 761 099
- US-A- 6 118 300

## Description

### TECHNICAL FIELD

Examples of the present disclosure generally relate to electronic circuits and, in particular, to a cascaded lookup-table (LUT) carry logic circuit.

### BACKGROUND

Programmable integrated circuits (ICs) are often used to implement digital logic operations according to user configurable input. Example programmable ICs include complex programmable logic devices (CPLDs) and field programmable gate arrays (FPGAs). CPLDs often include several function blocks that are based on a programmable logic array (PLA) architecture with sum-of-products logic. A configurable interconnect matrix transmits signals between the function blocks.

One type of FPGA includes an array of programmable tiles. The programmable tiles comprise various types of logic blocks, which can include, for example, input/output blocks (IOBs), configurable logic blocks (CLBs), dedicated random access memory blocks (BRAM), multipliers, digital signal processing blocks (DSPs), processors, clock managers, delay lock loops (DLLs), bus or network interfaces such as Peripheral Component Interconnect Express (PCIe) and Ethernet and so forth. Each programmable tile typically includes both programmable interconnect and programmable logic. The programmable interconnect typically includes a large number of interconnect lines of varying lengths interconnected by programmable interconnect points (PIPs). The programmable logic implements the logic of a user design using programmable elements that can include, for example, function generators, registers, arithmetic logic, and so forth.

WO 98/51013 A1 describes a carry logic circuit for a field programmable gate array (FPGA) which allows a carry input signal to be propagated through the carry logic circuit without passing through a multiplexer of another series connected circuit element. The carry logic circuit uses a function generator of the FPGA to provide a propagate signal in response to first and second input signals provided to the carry logic circuit. Also described are methods for performing a carry logic function in an FPGA.

### SUMMARY

The invention is defined by the independent claims. A cascaded lookup-table (LUT) carry logic circuit is described. According to an aspect of the invention, a configurable logic element for a programmable integrated circuit (IC) includes a first lookup-table (LUT) including first inputs and first outputs, and first sum logic and first carry logic coupled between the first inputs and the first outputs; a second LUT including second inputs and second outputs, and second sum logic coupled between the second inputs and the second outputs; and first and second cascade multiplexers respectively coupled to the first and second LUTs, an input of the second cascade multiplexer coupled to an output of the first carry logic in the first LUT.

In an example, a programmable integrated circuit (IC), includes a configuration memory; and a plurality of configurable logic elements coupled to the configuration memory. Each of the plurality of configurable logic elements includes a first lookup-table (LUT) including first inputs and first outputs, and first sum logic and first carry logic coupled between the first inputs and the first outputs; a second LUT including second inputs and second outputs, and second sum logic coupled between the second inputs and the second outputs; and first and second cascade multiplexers respectively coupled to the first and second LUTs, an input of the second cascade multiplexer coupled to an output of the first carry logic in the first LUT.

According to a second aspect of the invention, a method of configuring a programmable integrated circuit (IC) includes configuring a first lookup-table (LUT) in a configurable logic element to compute a first sum, the first LUT including first inputs and first outputs, and first sum logic and first carry logic coupled between the first inputs and the first outputs; configuring a second LUT in the configurable logic element to compute a second sum, the second LUT including second inputs and second outputs, and second sum logic coupled between the second inputs and the second outputs; and configuring a cascade multiplexer to couple an output of the first carry logic in the first LUT to an input of the second sum logic in the second LUT.

In another example, a lookup-table (LUT) cascading circuit is described.

In an example, a LUT for a programmable integrated circuit (IC) includes a plurality of input terminals, and a cascading input coupled to at least one other LUT in the programmable IC. The LUT further includes LUT logic having a plurality of LUTs each coupled to a common set of the input terminals. The LUT further includes a plurality of multiplexers having inputs coupled to outputs of the plurality of LUTs, and an output multiplexer having inputs coupled to outputs of the plurality of multiplexers. The LUT further includes a plurality of cascading multiplexers each having an output coupled to a control input of a respective one of the plurality of multiplexers, each of the plurality of cascading multiplexers comprising a plurality of inputs, at least one of the plurality of inputs coupled to the cascading input.

In another example, a programmable IC includes a configuration memory; and at least one configurable logic element (CLE) coupled to the configuration memory. The at least one CLE includes a plurality of. Each of the plurality of LUTs includes an output terminal and a cascading input. A cascading input of a first LUT of the plurality of LUTs is coupled to the output terminal of a second LUT of the plurality of LUTs.

In another example, a method of operating a LUT in a programmable IC includes: coupling a common set of input signals to a plurality of LUTs in LUT logic; coupling a cascade input to each of a plurality of cascading multiplexers, the cascade input coupled to at least one other LUT in the programmable IC; controlling at least one of the plurality of cascading multiplexers to select a signal of the cascade input; and coupling output of the cascading multiplexers to multiplexer logic operable to select among outputs of the plurality of LUTs in the LUT logic.

These and other aspects may be understood with reference to the following detailed description.

### BRIEF DESCRIPTION OF THE DRAWINGS

So that the manner in which the above recited features can be understood in detail, a more particular description, briefly summarized above, may be had by reference to example implementations, some of which are illustrated in the appended drawings. It is to be noted, however, that the appended drawings illustrate only typical example implementations and are therefore not to be considered limiting of its scope.
Fig. 1A illustrates an example architecture of an FPGA.
Fig. 1B is a block diagram depicting a higher-level view of the FPGA of Fig. 1 according to an example.
Fig. 2 is a block diagram depicting a floorplan of the programmable fabric of the FPGA of Fig. 1.
Fig. 3 is a block diagram depicting a configurable logic element according to an example.
Fig. 4 is a block diagram depicting a configurable logic element according to another example.
Fig. 5 is a flow diagram depicting a method of configuring a programmable integrated circuit (IC) according to an example.
Fig. 6 is a block diagram depicting a portion of a floorplan of the programmable fabric of the FPGA of Figs. 1A-1B.
Fig. 7 is a block diagram depicting a LUT according to an example.
Fig. 8 is a block diagram depicting an example circuit comprising a chain of LUTs that implement a wide combinatorial function.
Fig. 9 is a block diagram depicting an example circuit 500 comprising a plurality of LUTs that implement a multiplexer.
Fig. 10 is a flow diagram depicting a method of operating a LUT in a programmable IC according to an example.

To facilitate understanding, identical reference numerals have been used, where possible, to designate identical elements that are common to the figures. It is contemplated that elements of one example may be beneficially incorporated in other examples.

### DETAILED DESCRIPTION

Various features are described hereinafter with reference to the figures. It should be noted that the figures may or may not be drawn to scale and that the elements of similar structures or functions are represented by like reference numerals throughout the figures. It should be noted that the figures are only intended to facilitate the description of the features. They are not intended as an exhaustive description of the claimed invention or as a limitation on the scope of the claimed invention. In addition, an illustrated embodiment need not have all the aspects or advantages shown. An aspect or an advantage described in conjunction with a particular embodiment is not necessarily limited to that embodiment and can be practiced in any other embodiments even if not so illustrated, or if not so explicitly described.

A cascaded lookup-table (LUT) carry logic circuit is described. In an example, a configurable logic element (CLE) for a programmable integrated circuit (IC), such as an FPGA, includes a pair of lookup tables (LUTs). A first lookup-table (LUT) includes first inputs and first outputs, and first sum logic and first carry logic coupled between the first inputs and the first outputs. A second LUT includes second inputs and second outputs, and second sum logic coupled between the second inputs and the second outputs. The CLE includes first and second cascade multiplexers respectively coupled to the first and second LUTs. An input of the second cascade multiplexer is coupled to an output of the first carry logic in the first LUT. In another example, carry logic can also be incorporated into the second LUT in the LUT pair.

In the example CLE described herein, the sum and carry logic is incorporated into one or more LUTs of the CLE. Carry initialization can be performed by the cascade multiplexers. The cascade multiplexers speed up generic LUT-to-LUT direct connections. Both sum and carry out outputs are directly provided by the LUTs. This allows output multiplexers driven by these signals to be reduced in size, since such output multiplexers would otherwise require separate outputs for sum, carry, and outputs of the LUTs. Since each of the LUTs includes a cascade multiplexer coupled thereto, it is possible to start/initialize a carry chain at every LUT, which enables more efficient multiple carry chain packing. These and further aspects are described below with respect to the following figures.

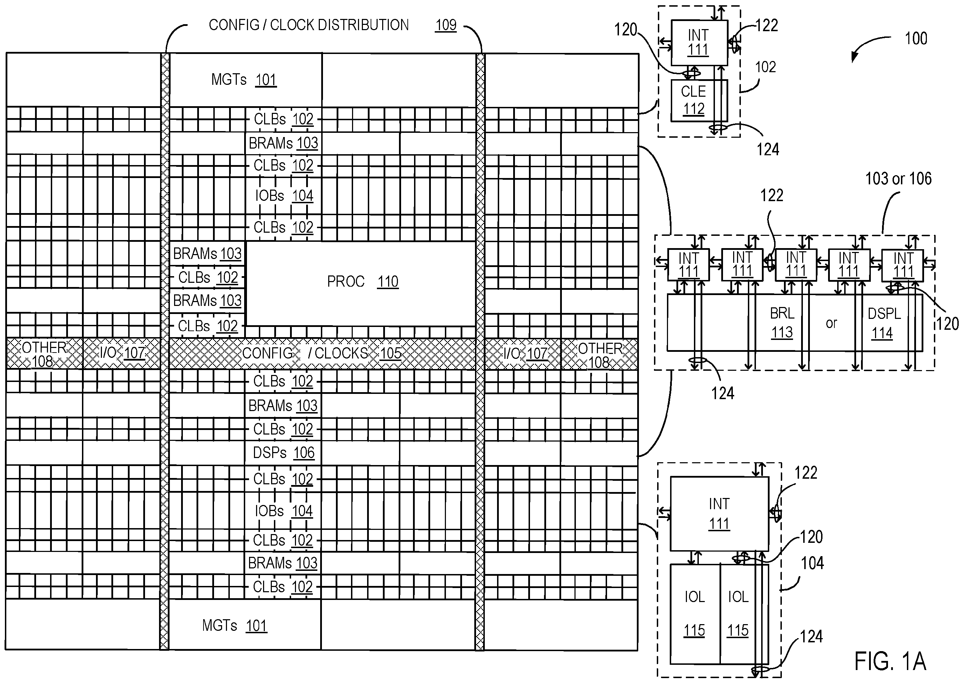

Fig. 1A illustrates an example architecture of an FPGA 100 that includes a large number of different programmable tiles including multi-gigabit transceivers ("MGTs") 101, configurable logic blocks ("CLBs") 102, random access memory blocks ("BRAMs") 103, input/output blocks ("IOBs") 104, configuration and clocking logic ("CONFIG/CLOCKS") 105, digital signal processing blocks ("DSPs") 106, specialized input/output blocks ("I/O") 107 (e.g., configuration ports and clock ports), and other programmable logic 108, such as digital clock managers, analog-to-digital converters, system monitoring logic, and so forth. Some FPGAs also include dedicated processor blocks ("PROC") 110.

In some FPGAs, each programmable tile can include at least one programmable interconnect element ("INT") 111 having connections to input and output terminals 120 of a programmable logic element within the same tile, as shown by examples included at the top of Fig. 1A. Each programmable interconnect element 111 (also referred to as "interconnect element 111") can also include connections to interconnect segments 122 of adjacent programmable interconnect element(s) in the same tile or other tile(s). Each programmable interconnect element 111 can also include connections to interconnect segments 124 of general routing resources between logic blocks (not shown). The general routing resources can include routing channels between logic blocks (not shown) comprising tracks of interconnect segments (e.g., interconnect segments 124) and switch blocks (not shown) for connecting interconnect segments. The interconnect segments of the general routing resources (e.g., interconnect segments 124) can span one or more logic blocks. The programmable interconnect elements 111 taken together with the general routing resources implement a programmable interconnect structure ("programmable interconnect") for the illustrated FPGA. As described further below, in some examples, some or all of the interconnect elements 111 can include additional circuitry for efficient implementation of TCAMs.

In an example implementation, a CLB 102 can include a configurable logic element ("CLE") 112 that can be programmed to implement user logic plus a single programmable interconnect element ("INT") 111. A BRAM 103 can include a BRAM logic element ("BRL") 113 in addition to one or more programmable interconnect elements. Typically, the number of interconnect elements included in a tile depends on the height of the tile. In the pictured example, a BRAM tile has the same height as five CLBs, but other numbers (e.g., four) can also be used. A DSP tile 106 can include a DSP logic element ("DSPL") 114 in addition to an appropriate number of programmable interconnect elements. An IOB 104 can include, for example, two instances of an input/output logic element ("IOL") 115 in addition to one instance of the programmable interconnect element 111. As will be clear to those of skill in the art, the actual I/O pads connected, for example, to the I/O logic element 115 typically are not confined to the area of the input/output logic element 115.

In the pictured example, a horizontal area near the center of the die (shown in Fig. 1A) is used for configuration, clock, and other control logic. Vertical columns 109 extending from this horizontal area or column are used to distribute the clocks and configuration signals across the breadth of the FPGA.

Some FPGAs utilizing the architecture illustrated in Fig. 1A include additional logic blocks that disrupt the regular columnar structure making up a large part of the FPGA. The additional logic blocks can be programmable blocks and/or dedicated logic. For example, processor block 110 spans several columns of CLBs and BRAMs. The processor block 110 can include various components ranging from a single microprocessor to a complete programmable processing system of microprocessor(s), memory controllers, peripherals, and the like.

Note that Fig. 1A is intended to illustrate only an exemplary FPGA architecture. For example, the numbers of logic blocks in a row, the relative width of the rows, the number and order of rows, the types of logic blocks included in the rows, the relative sizes of the logic blocks, and the interconnect/logic implementations included at the top of Fig. 1A are purely exemplary. For example, in an actual FPGA more than one adjacent row of CLBs is typically included wherever the CLBs appear, to facilitate the efficient implementation of user logic, but the number of adjacent CLB rows varies with the overall size of the FPGA. In another example, an FPGA can include an entire processing system (e.g., processor, memory, peripherals, etc.) instead of, or in addition to, the processor block 110. In such an implementation, a System-on-Chip (Soc) can include a programmable fabric (programmable logic as shown in FPGA 100) in communication with a processing system.

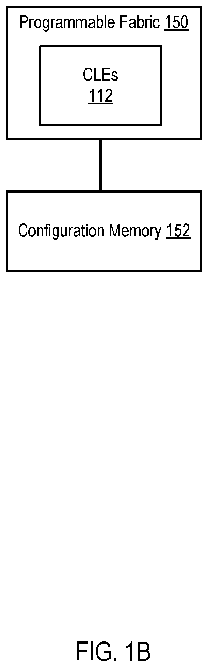

Fig. 1B is a block diagram depicting a higher-level view of the FPGA 100 according to an example. The FPGA 100 includes a programmable fabric 150, which can include the various programmable tiles described above. The programmable fabric 150 is coupled to a configuration memory 152. The configuration memory 152 comprises a random access memory (RAM), such as a static RAM (SRAM) or the like. The programmable fabric 150 can also include CLEs 112 having cascaded LUT carry logic as described herein. The configuration memory 152 can be loaded with a configuration bitstream for programming ("configuring") the programmable fabric 150. For example, a configuration bitstream can be loaded into the configuration memory 152 to configure the CLEs 112 of the programmable fabric 150, as described herein.

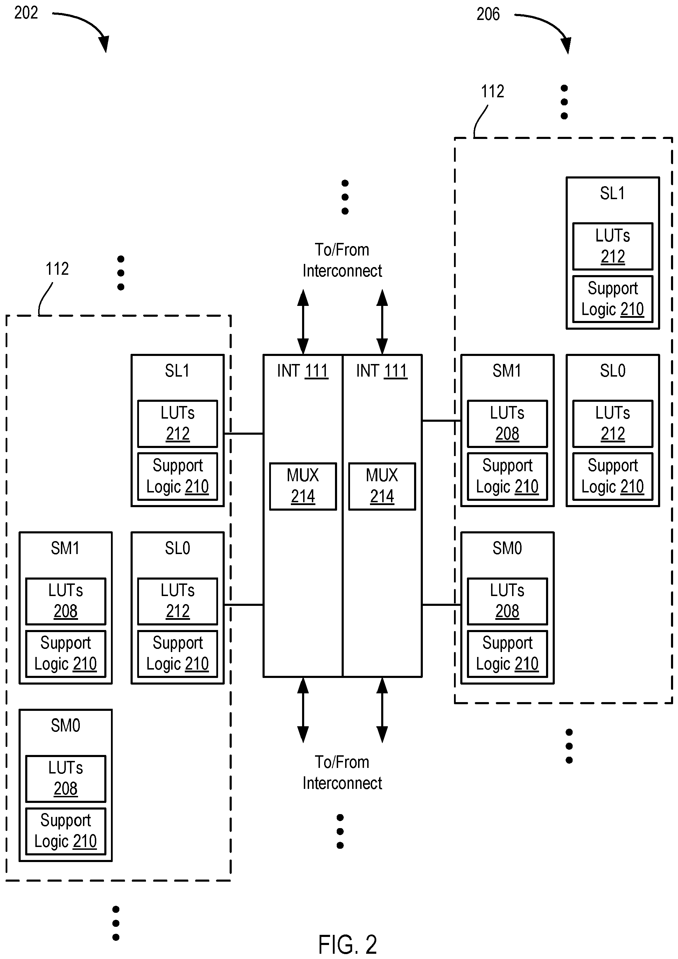

Fig. 2 is a block diagram depicting a floorplan of the programmable fabric 150 of the FPGA 100. Fig. 2 shows two columns 202 and 206 of programmable tiles in the programmable fabric 150. The programmable tiles in the columns 202 and 206 comprise CLEs 112. In each of the columns 202 and 206, only one CLE 112 is shown, but the columns 202 and 206 generally include a plurality of CLEs. Each of the CLEs 112 is coupled to an interconnect element 111.

Each of the CLEs 112 comprises four slices SM1-SM0 and SL0-SL1. The slices SM0-SL1 are of one type (type "M"), the slices SL0-SL1 are of another type (type "L"). The type "M" slices SM0 and SM1 include lookup tables (LUTs) 208 and support logic 210. The LUTs 208 can be configured as function generators to perform any combinatorial function having a plurality of inputs and a plurality of outputs. The LUTs 208 can also be configured as a LUT-RAM configured to store a plurality of bits. The support logic 210 can include flip-flops, multiplexers, carry-chain logic, and the like that support the LUTs 208. The type "L" slices SL0 and SL1 include LUTs 212 and support logic 210. The LUTs 212 can be configured as function generators, but not as LUT-RAM. The architecture shown in Fig. 2 is just one example. In other examples, all LUTs in a CLE 112 can comprise LUT-RAMs (every slice is of type "M"), or all LUTs in a CLE 112 can comprise LUTs that cannot be configured as a RAM (every slice is of type "L").

In the example, the type "L" slices SL0 and SL1 in the column 202 are adjacent the type "M" slices SM0 and SM1 in the column 206 having two interconnect elements 111 therebetween. The slices SL0-SL1 in the column 202 are coupled to one of the interconnect elements 111, and the slices SM0-SM1 in the column 206 are coupled to another of the interconnect elements 111. The interconnect elements 111 can be coupled to each other. Each of the interconnect elements 111 includes multiplexers 214. Different ones of the multiplexers 214 can have different inputs, such as inputs from the CLE 112 in the column 202, inputs from the CLE 112 in the column 206, inputs from multiplexers 214 in another interconnect element 111, or inputs from the interconnect. Likewise, different ones of the multiplexers 214 can have different outputs, such as outputs to the CLE 112 in the column 202, outputs to the CLE 112 in the column 206, outputs to another interconnect element 111, or outputs to the interconnect.

As described herein, the LUTs 208 and/or the LUTs 212 can include internal sum and carry logic, removing the need for such sum and carry logic to be included in the support logic 210. This reduces output multiplexer costs for the CLE 112. This also results in fewer possible critical paths, which optimizes performance of the CLE 112. Further, carry chains can be initialized at any LUT in the CLE 112, which enables packing of multiple carry chains in finer granularities.

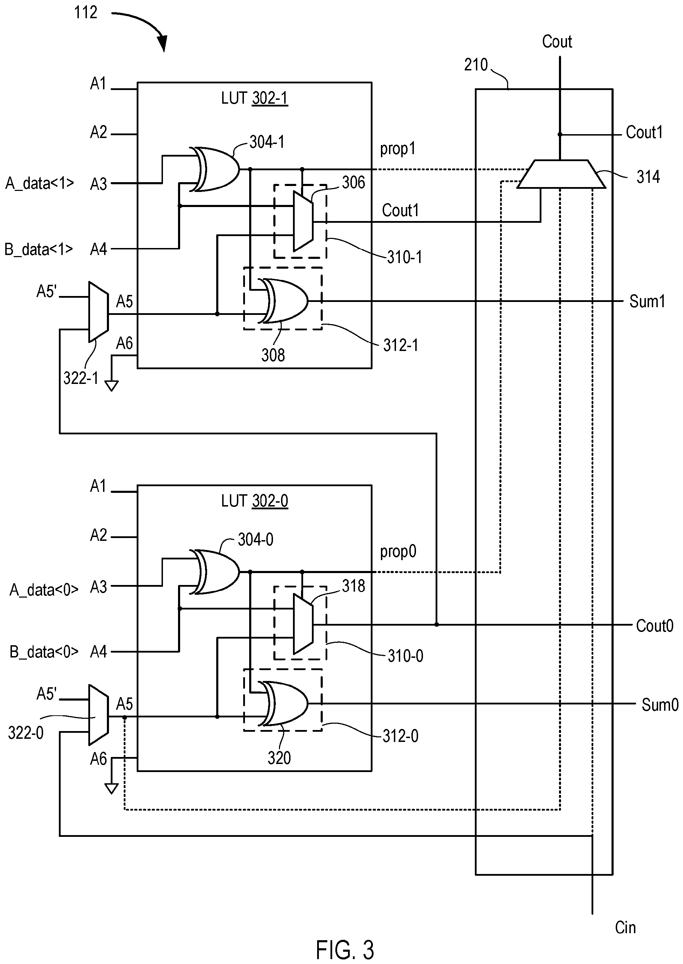

Fig. 3 is a block diagram depicting a configurable logic element 112 according to an example. In the present example, the configurable logic element 112 includes a pair of LUTs 302-0 and 302-1 (collectively LUTs 302). While only two LUTs are shown in the example, as described above, a CLE 112 can have one or more slices, each having one or more LUTs.

Each of the LUTs 302 includes sum logic 312 and carry logic 310 therein. In the example, the LUT 302-0 includes sum logic 312-0 and carry logic 310-0, and the LUT 302-1 includes sum logic 312-1 and carry logic 310-1. In the example, the sum logic 312 comprises an exclusive OR (XOR) gate, and the carry logic 310 comprises a multiplexer. Thus, the sum logic 312-0 comprises a logic gate 320, and the sum logic 312-1 comprises a logic gate 308. In the example, each of the logic gates 308 and 320 comprises an XOR gate. Likewise, the carry logic 310-0 comprises a multiplexer 318, and the carry logic 310-1 comprises a multiplexer 306. The LUT 302-0 further includes a logic gate 304-0, and the LUT 302-1 further includes a logic gate 304-1. In the example, each of the logic gates 304-0 and 304-1 comprises an XOR gate.

Each of the LUTs 302 includes six inputs designated A1 through A6. In the LUT 302-0, the inputs A3 and A4 are coupled to inputs of the logic gate 304-0. The input A5 is coupled to an output of a cascade multiplexer 322-0. The input A6 is shown as being connected to a reference voltage (e.g., electrical ground). In the present example, the inputs A1 and A2 are unconnected. An output of the logic gate 304-0 is designated prop0. A control input of the multiplexer 318 is coupled to receive prop0. Inputs of the multiplexer 318 are coupled to inputs A4 and A5. Inputs of the logic gate 320 are coupled to the input A5 and the output of the logic gate 304-0 (prop0). An output of the multiplexer 318 is designated Cout0, and the output of the logic gate 320 is designated Sum0.

In the LUT 302-1, the inputs A3 and A4 are coupled to inputs of the logic gate 304-1. The input A5 is coupled to an output of a cascade multiplexer 322-1. The input A6 is shown as being connected to a reference voltage (e.g., electrical ground). In the present example, the inputs A1 and A2 are unconnected. An output of the logic gate 304-1 is designated prop1. A control input of the multiplexer 306 is coupled to receive prop1. Inputs of the multiplexer 306 are coupled to inputs A4 and A5. Inputs of the logic gate 308 are coupled to the input A5 and the output of the logic gate 304-1 (prop1). An output of the multiplexer 306 is designated Cout1', and the output of the logic gate 308 is designated Sum1.

One input of the cascade multiplexer 322-0 is designated A5', and another input of the cascade multiplexer 322-0 is coupled to a node Cin. One input of the cascade multiplexer 322-1 is designated A5', and another input of the cascade multiplexer 322-1 is coupled to the output of the multiplexer 318 (Cout0).

In the example, the support logic 210 for the CLE 112 includes a carry chain multiplexer 314. An output of the carry chain multiplexer 314 is designated by Cout. A control interface of the carry chain multiplexer 314 can be coupled to receive prop0, prop1, or both. An input of the carry chain multiplexer 314 is coupled to receive Cout1'. Other input(s) of the carry chain multiplexer 314 can be coupled to receive the output of the cascade multiplexer 322-0, Cin, or both.

In operation, the LUTs 302-0 and 302-1 compute the sum of data words A_data and B_data. In the present example, data words A_data and B_data each have two bits designated <0> and <1>. Inputs A3 and A4 of the LUT 302-0 receive A_data<0> and B_data<0>, respectively. Inputs A3 and A4 of the LUT 302-1 receive A_data<1> and B_data<1>, respectively.

The logic gate 304-0 computes the sum of A_data<0> and B_data<0> (i.e., prop0 = A_data<0> + B_data<0>). The logic gate 320 adds a carry bit to the sum of A_data<0> and B_data<0> (i.e., sum0 = A_data<0> + B_data<0> + carry). The carry bit is output by the cascade multiplexer 322-0, which can be input through A5' or through Cin (the carry input to the CLE 112). The multiplexer 318 outputs a carry bit for the sum operation performed by LUT 302-0 (designated Cout0).

The logic gate 304-1 computes the sum of A_data<1> and B_data<1> (i.e., prop1 = A_data<1> + B_data<1>). The logic gate 308 adds a carry bit to the sum of A_data<1> and B_data<1> (i.e., sum1 = A_data<1> + B_data<1> + carry). The carry bit is output by the cascade multiplexer 322-1, which can be input through A5' or through the output of the multiplexer 318 (e.g., Cout0). For determining A_data + B_data, the multiplexer 322-1 selects Cout0 as the carry bit. The multiplexer 306 outputs a carry bit for the sum operation performed by LUT 302-1 (designated Cout1').

The carry chain multiplexer 314 outputs a carry bit for the CLE 112. The carry bit for the CLE 112 can be Cout1 (for the operation A_data + B_data). For other operations, it is also possible for the Cout to be Cin (carry pass through) or the output of the cascade multiplexer 322-0. The CLE 112 shown in Fig. 3 can be replicated and chained together to compute the sum or A_data and B_data having an arbitrary number of bits.

In the example of Fig. 3, the sum and carry logic is incorporated into the LUTs 302 of the CLE 112. Carry initialization can be performed by the cascade multiplexers 322. The cascade multiplexers 322 speed up generic LUT-to-LUT direct connections. Both sum and carry out outputs are directly provided by the LUTs 302. This allows output multiplexers driven by these signals (e.g., within interconnect 111) to be reduced in size, since such output multiplexers would otherwise require separate outputs for sum, carry, and outputs of the LUTs 302. Since each of the LUTs 302 includes a cascade multiplexer 322 coupled thereto, it is possible to start/initialize a carry chain at every LUT, which enables more efficient multiple carry chain packing. Further, the sum output is not dedicated and the logic gate 304 that computes the sum can be some other function other than XOR.

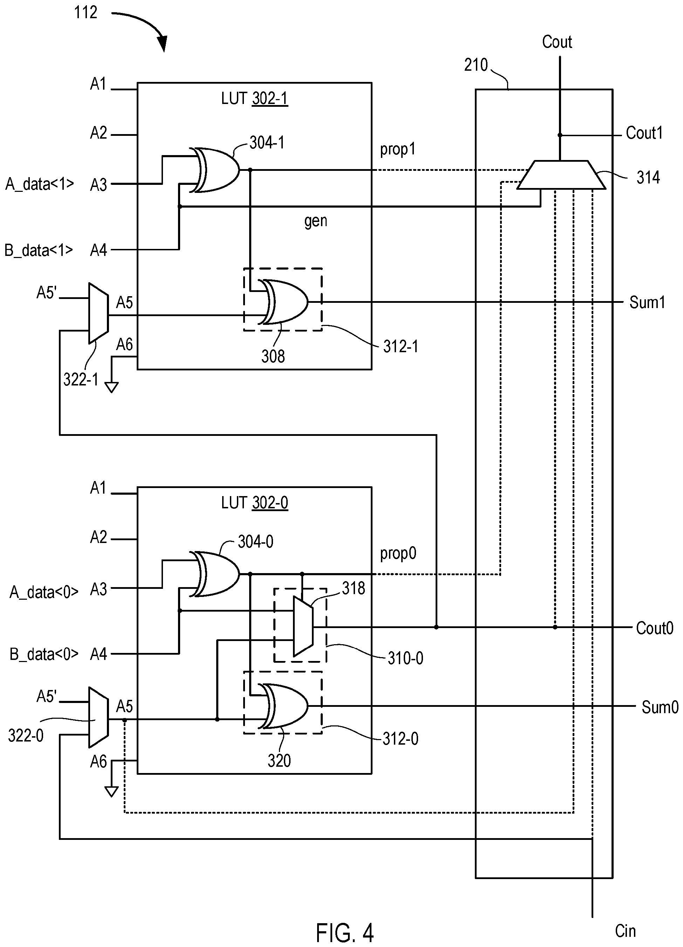

Fig. 4 is a block diagram depicting a configurable logic element 112 according to another example. Elements that are the same or similar to those described above are designated with identical reference numerals. In the present example, the output of the multiplexer 318 in the carry logic 310-0 (CoutO) is coupled to an input of the carry chain multiplexer 314. Further, the carry logic 310-1 is omitted from the LUT 302-1. Rather, the input A4 of the LUT 302-1 is coupled to an input of the carry chain multiplexer 314. The remainder of the configurable logic element 112 is implemented as described above with respect to Fig. 3.

In configurable logic element 112 as shown in Fig. 4, the input of the carry chain multiplexer 314 expands to receive the carry out (CoutO) from the LUT 302-0 directly. In this manner, the carry out (CoutO) from the LUT 302-0 does not have to propagate through to the LUT 302-1 in order to get to the carry chain multiplexer 314. Further, since the carry out (CoutO) of the LUT 302-0 is connected directly to the multiplexer 314, the carry logic 310-1 can be removed from the

In the examples of Figs. 3 and 4, two bits of carry (Cout0 and Cout1) are shown. In general, the circuits in Figs. 3 and 4 can be expanded to generate N bits of carry, where N is positive integer. In such examples, the carry chain multiplexer 314 can include increased width to accommodate the additional bits of carry generated by other LUTs. Further, in the examples discussed above, the carry logic structure is described with respect to addition operations. In general, the carry logic structure described herein can be used to perform all or a portion of other types of arithmetic operations.

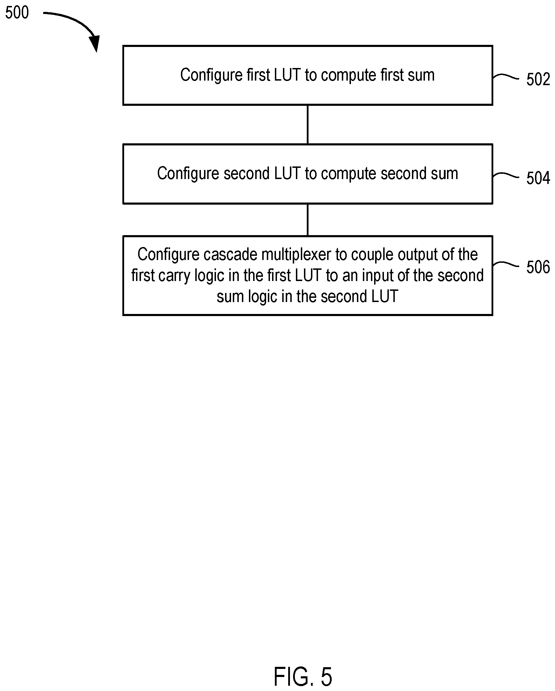

Fig. 5 is a flow diagram depicting a method 500 of configuring a programmable integrated circuit (IC) according to an example. The method 500 begins at block 502, where a first LUT in a CLE is configured to compute a first sum, the first LUT including first inputs and first outputs, and first sum logic and first carry logic coupled between the first inputs and outputs. At block 504, a second LUT in the CLE is configured to compute a second sum, the second LUT including second inputs and second outputs, and second sum logic and second carry logic coupled between the second inputs and outputs. At block 506, a cascade multiplexer is configured to couple an output of the first carry logic in the first LUT to an input of the second sum logic in the second LUT. The method 500 can be repeated for one or more additional LUTs to compute the sum of data words having an arbitrary number of bits.

Some other examples, generally relate to electronic circuits and, in particular, to a look-up table (LUT) cascading circuit.

Referring back to Fig. 1B, in one example, the programmable fabric 150 can also include CLEs 112 having look-up tables (LUTs) 154. The LUTs 154 can include cascading inputs, as described herein.

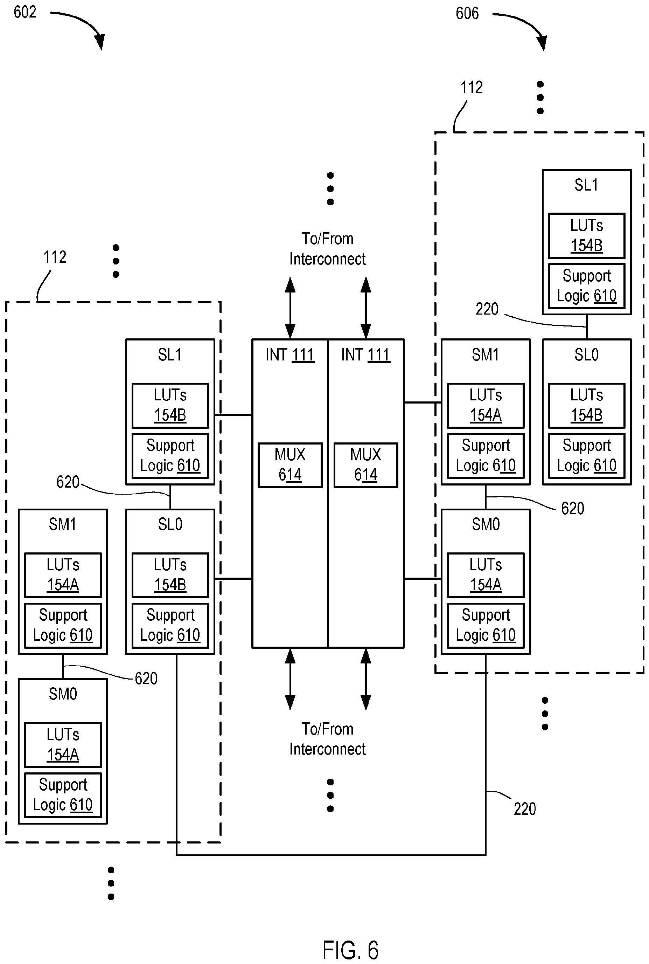

Now turning to Fig. 6, another block diagram depicting a portion of a floorplan of the programmable fabric 150 of the FPGA 100. Fig. 6 shows two columns 602 and 606 of programmable tiles in the programmable fabric 150. The programmable tiles in the columns 602 and 606 comprise CLEs 612. In each of the columns 602 and 606, only one CLE 612 is shown, but the columns 602 and 606 generally include a plurality of CLEs. Each of the CLEs 612 is coupled to an interconnect element 611.

Each of the CLEs 612 comprises four slices SM0-SM1 and SL0-SL1. The slices SM0-SL1 are of one type (type "M"), the slices SL0-SL1 are of another type (type "L"). The type "M" slices SM0 and SM1 include LUTs 154A and support logic 610. The LUTs 154A can be configured as function generators to perform any combinatorial function having a plurality of inputs and a plurality of outputs. The LUTs 154A can also be configured as a LUT-RAM configured to store a plurality of bits. The support logic 610 can include flip-flops, multiplexers, carry-chain logic, and the like that support the LUTs 154A. The type "L" slices SL0 and SL1 include LUTs 154B and support logic 610. The LUTs 154B can be configured as function generators, but not as LUT-RAM. The architecture shown in Fig. 6 is just one example. In other examples, all LUTs in a CLE 612 can comprise LUT-RAMs (every slice is of type "M"), or all LUTs in a CLE 612 can comprise LUTs that cannot be configured as a RAM (every slice is of type "L").

Both types of LUTs 154A and 154B can have cascading connections 620. The cascading connections 620 enable LUT-to-LUT connections without using the programmable interconnect (e.g., INT 611 and MUX 614). The cascading connections 620 are shown generally in Fig. 2 as inter-slice connections (e.g., LUT-to-LUT connections between LUTs in two different slices). The cascading connections 620 can also be inter-CLE connections (e.g., between LUTs in two different CLEs 612). The cascading connections 620 can also be intra-slice connections (e.g., LUT-to-LUT connections between LUTs in the same slice).

In the example, the type "L" slices SL0 and SL1 in the column 602 are adjacent the type "M" slices SM0 and SM1 in the column 606 having two interconnect elements 611 therebetween. The slices SL0-SL1 in the column 602 are coupled to one of the interconnect elements 611, and the slices SM0-SM1 in the column 606 are coupled to another of the interconnect elements 611. The interconnect elements 611 can be coupled to each other. Each of the interconnect elements 611 includes multiplexers 614. Different ones of the multiplexers 214 can have different inputs, such as inputs from the CLE 612 in the column 602, inputs from the CLE 612 in the column 606, inputs from multiplexers 614 in another interconnect element 611, or inputs from the interconnect. Likewise, different ones of the multiplexers 614 can have different outputs, such as outputs to the CLE 612 in the column 602, outputs to the CLE 612 in the column 606, outputs to another interconnect element 611, or outputs to the interconnect.

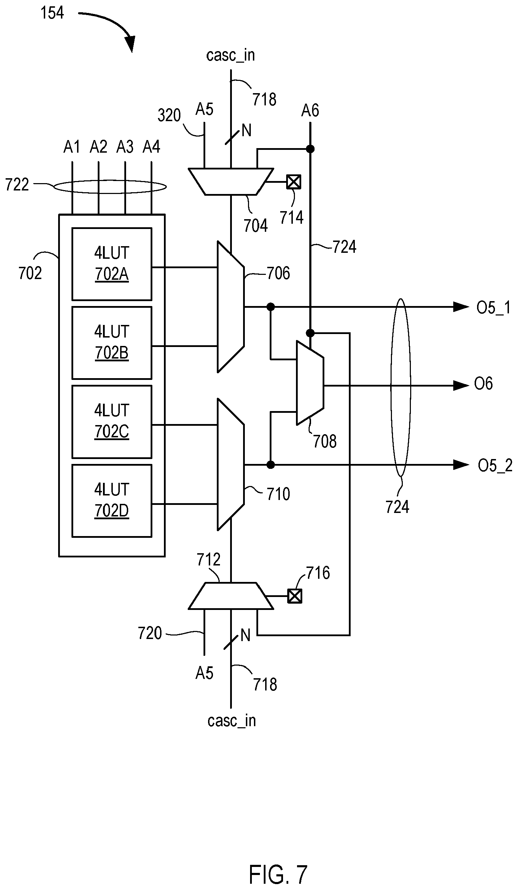

Fig. 7 is a block diagram depicting a LUT 154 according to an example. The LUT 154 includes LUT logic 702, a multiplexer 704, a multiplexer 706, a multiplexer 708, a multiplexer 710, and a multiplexer 712. The LUT 154 includes six inputs designated A1 through A6. The LUT 154 also includes a cascading input designated casc_in. The cascading input can be a single input or can be a bus of signals. In general, the cascading input includes N bits or signals, where N is a positive integer. The LUT 154 includes outputs designated O5_1, O5_2, and O6.

The LUT logic 702 includes four 4-input LUTs 702A, 702B, 702C, and 702D. In an example, the LUT logic 702 can include at least four LUTs 702. A 4-input LUT is also referred to herein as a "4LUT." Each 4LUT 702A-702D is coupled to common input terminals 722. Input terminals 722 provide the inputs A1, A2, A3, and A4 to each of the 4LUTs 702A-702D. An output of the 4LUT 702A is coupled to an input of the multiplexer 706, and an output of the 4LUT 702B is coupled to another input of the multiplexer 706. Together, the 4LUTs 702A and 702B comprise a first half of the LUT 154. An output of the 4LUT 702C is coupled to an input of the multiplexer 710, and an output of the 4LUT 702D is coupled to another input of the multiplexer 710. Together, the 4LUTs 702C and 702D comprise a second half of the LUT 154. An output of the multiplexer 706 provides the output O5_1 (output of the first half of the LUT 154), and an output of the multiplexer 710 provides the output O5_2 (output of the second half of the LUT 154).

The output of the multiplexer 706 is also coupled to an input of the multiplexer 708, and the output of the multiplexer 710 is also coupled to another input of the multiplexer 708. An output of the multiplexer 708 provides the output O6 of the LUT 154. Together, the outputs O5_1, O5_2, and O6 are provided by output terminals 724 of the LUT 154. One or more of the output terminals 724 can be coupled to casc_in of one or more additional LUTs in the FPGA. The multiplexer 708 is also referred to herein as the "output multiplexer." An output of the multiplexer 704 is coupled to a control input of the multiplexer 706. One input of the multiplexer 704 is coupled to an input terminal 720, which provides the input A5 of the LUT 154. Another input of the multiplexer 704 is coupled to an input terminal 724, which provides the input A6 of the LUT 154. One or more additional input terminals of the multiplexer 704 is/are coupled to input 718, which provides casc_in. A control input of the multiplexer 704 is coupled to a control terminal 714. The control terminal 714 can receive a signal from another circuit in the FPGA, such as a memory (e.g., BRAM, LUTRAM, configuration memory, etc.).

An output of the multiplexer 712 is coupled to a control input of the multiplexer 710. One input of the multiplexer 712 is coupled to the input terminal 720, which provides the input A5 of the LUT 154. Another input of the multiplexer 712 is coupled to the input terminal 724, which provides the input A6 of the LUT 154. One or more additional input terminals of the multiplexer 712 is/are coupled to the input 718, which provides casc_in. A control input of the multiplexer 712 is coupled to a control terminal 716. The control terminal 716 can receive a signal from another circuit in the FPGA, such as a memory (e.g., BRAM, LUTRAM, configuration memory, etc.). The multiplexers 704 and 712 are also referred to herein as "cascading multiplexers."

In operation, each of the 4LUTs 702A-702D can implement an arbitrary 4-input function based on inputs A1-A4. The multiplexer 706 selects output from one of 4LUT 702A or 4LUT 702B as the output O5_1 for the first half of the LUT 154. The multiplexer 710 selects output from one of 4LUT 702C or 4LUT 702D as the output O5_2 for the second half of the LUT 154. In this manner, the LUT 154 can implement two 5-input LUTs that can be used to implement two 5-input functions. The multiplexer 708 selects among the outputs of the multiplexers 706 and 710 to provide the output O6 of the LUT 154. Thus, the LUT 154 can implement one 6-input LUT that can be used to implement a 6-input function.

In one configuration, multiplexers 704 and/or 712 can select input A5 to control the multiplexers 706 and/or 710, respectively. In another configuration, multiplexers 704 and/or 712 can select input A6 to control the multiplexers 706 and/or 710, respectively. In yet another configuration, multiplexers 704 and/or 712 can select one of the casc_in input(s) to control the multiplexers 706 and/or 710, respectively. The inputs 718 can be coupled to one or more output terminals of one or more other LUTs in the FPGA. In this manner, the LUT 154 can be directly coupled to one or more other LUTs in the FPGA through casc_in. As such, LUTs 154 can be chained together to synthesize multi-level functions, some examples of which are described below.

Multiplexing the casc_in input with the A5 input has the advantages of not increasing the delay on the fastest LUT input, and enabling different signals to feed top and bottom halves of the LUT. The multiplexers 704 and 712 allow for the creation of fast LUT-to-LUT connections by connection the output of one LUT to the casc_in of another LUT. In some examples, the casc_in input can include a plurality of signals. In such an example, the top half of the LUT 154 can use a different casc_in signal than the bottom half of the LUT 154, allowing for the implementation of wide multiplexer trees.

The LUT 154 shown in Fig. 7 can be scaled to provide a different number of LUTs and inputs. For example, LUT logic 702 can include more than four LUTs, and the LUTs in LUT logic 702 can include more than four inputs. The multiplexers 706 and 710 are part of multiplexing logic that selects among outputs of the LUTs in the LUT logic 702. In some examples, such multiplexing logic can include more than two multiplexers, each coupled to a cascading multiplexer. As such, while two cascading multiplexers 704 and 712 are shown, the LUT 154 can include a plurality of cascading multiplexers.

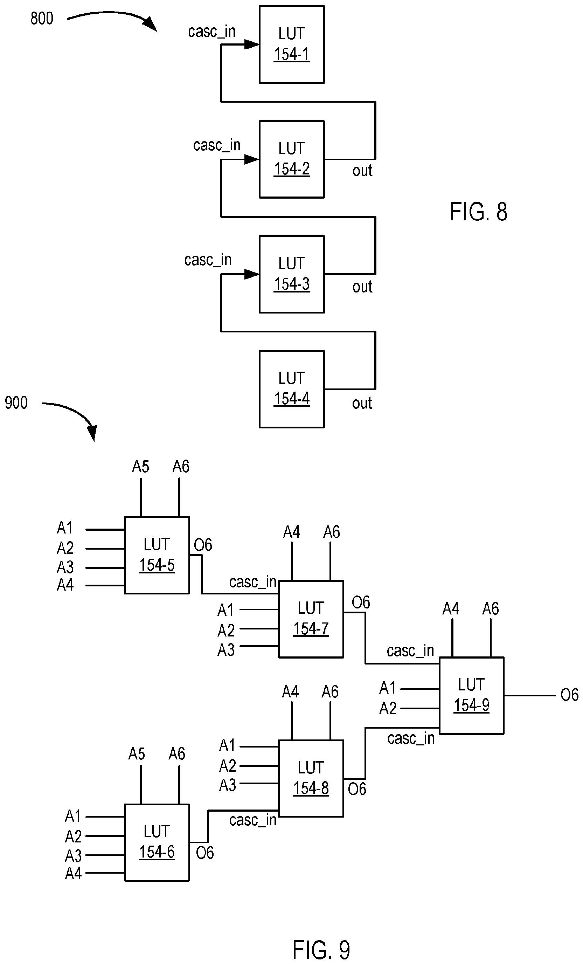

Fig. 8 is a block diagram depicting an example circuit 800 comprising a chain of LUTs 154-1 through 154-4. The casc_in input of the LUT 154-1 is coupled to an output of the LUT 154-2. The casc_in input of the LUT 154-2 is coupled to an output of the LUT 154-3. The casc_in input of the LUT 154-3 is coupled to an output of the LUT 154-4. The multiplexer 604 and/or the multiplexer 612 in each of the LUTs 154-1 through 154-3 to select the respective outputs of the LUTs 154-2 through 154-4 at the casc_in inputs. In the example of Fig. 3, each LUT 154-1 through 154-3 includes five other inputs A1-A4 and A6 that can be used in addition to casc_in. The LUT 154-4 includes six inputs A1-A6 that can be used. As such, the circuit 400 can implement a 21-input function, the output of which is provided by the LUT 154-1. In other examples, the LUTs 154 can have a different number of input terminals, but in general the cascading inputs can be used to cascade LUTs and implement a wide combinatorial function.

Fig. 9 is a block diagram depicting an example circuit 900 comprising a plurality of LUTs 154-5 through 154-9. Assuming an implementation as shown in Fig. 7, the circuit 900 implements a 16:1 multiplexer. Inputs of the 16:1 multiplexer include inputs A1 through A4 of the LUT 154-5, inputs A1 through A4 of the LUT 154-6, inputs A1 through A3 of the LUT 154-7, inputs A1 through A3 of the LUT 154-8, and inputs A1 and A2 of the LUT 154-9. An output of the 16:1 multiplexer is provided by the output O6 of the LUT 154-9. The control input of the 16:1 multiplexer comprises inputs A5-A6 of the LUT 154-5, inputs A5-A6 of the LUT 154-6, inputs A4 and A6 of the LUT 154-7, inputs A4 and A6 of the LUT 154-8, and inputs A4 and A6 of the LUT 154-9. The output O6 of the LUT 154-5 is coupled to the casc_in input of the LUT 154-7. The output O6 of the LUT 154-6 is coupled to the casc_in input of the LUT 154-8. Outputs O6 of the LUTs 154-7 and 154-8 are coupled to the casc_in input of the LUT 154-9. The present example assumes that the casc_in input of the LUT 154-9 is a bus comprising a plurality of signals.

The circuits 800 and 900 of Figs. 8 and 9 are just two examples of the types of circuits that can be formed using LUTs having cascading inputs as described herein. In general, for example, as shown in the example of Fig. 7, each LUT can include a casc_in input having one or more bits or signals. As such, each LUT can be coupled to one or more additional LUTs. The additional LUTs can be located in the same slice, in adjacent slice(s), and/or in adjacent CLE(s). A set of cascaded LUTs can be used to form wider versions of combinatorial functions, multiplexers, and the like that can be formed using a single LUT.

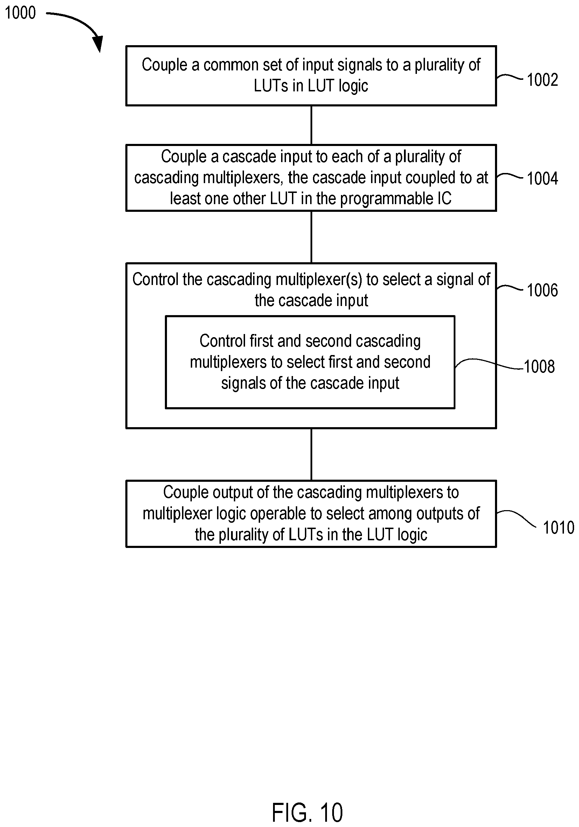

Fig. 10 is a flow diagram depicting a method 1000 of operating a LUT in a programmable IC according to an example. The method 1000 begins at step 1002, where a common set of input signals are coupled to a plurality of LUTs in LUT logic. For example, as shown in Fig. 7, inputs A1 through A4 are coupled to LUTs 702A through 702B.

At step 604, a cascade input is coupled to each of a plurality of cascading multiplexers, where the cascade input is coupled to at least one other LUT in the programmable IC. For example, as shown in Fig. 3, the input casc_in is coupled to multiplexers 304 and 312 in the LUT 154.
At step 1006, at least one of the cascading multiplexers is controlled to select a signal of the cascade input. For example, either or both of the multiplexers 704 and 712 can be controlled to select a signal of casc_in. In an example, the multiplexers 304 and 312 can be controlled using a memory in the programmable IC, such as configuration memory.

At step 1008, first and second cascading multiplexers are controlled to select first and second signals of the cascade input. The first signal can be different from the second signal. For example, as shown in Fig. 7, the casc_in input can be a bus having a plurality of signals, and the multiplexer 704 can select one of the casc_in signals, while the multiplexer 312 selects another of the casc_in signals.

At step 1010, output of the cascading multiplexers is coupled to multiplexer logic to select among outputs of the plurality of LUTs in the LUT logic. For example, as shown in Fig. 7, the outputs of the multiplexers 704 and 712 are coupled to multiplexers 706 and 710 to select among the outputs of the LUTs 702A through 702D.

Additional examples follow below.

In one example, a configurable logic element for a programmable integrated circuit (IC) may be provided. Such a configurable logic element may include: a first lookup-table (LUT) including first inputs and first outputs, and first sum logic and first carry logic coupled between the first inputs and the first outputs; a second LUT including second inputs and second outputs, and second sum logic coupled between the second inputs and the second outputs; and first and second cascade multiplexers respectively coupled to the first and second LUTs, an input of the second cascade multiplexer coupled to an output of the first carry logic in the first LUT.

Such configurable logic element may further include a carry chain multiplexer coupled to at least one of the first LUT or the second LUT.

In some such configurable logic element, the second LUT may include second carry logic, and an input of the carry chain multiplexer may be coupled to an output of the second carry logic in the second LUT.

Such configurable logic element may further include a carry input coupled to the first cascade multiplexer.

In some such configurable logic element, the carry input may be further coupled to an input of the carry chain multiplexer.

In some such configurable logic element, an input of the carry chain multiplexer may be coupled to an output of the first cascade multiplexer.

In some such configurable logic element, each of the first and second sum logic comprises an exclusive OR gate, and wherein the first carry logic comprises a multiplexer.

In some such configurable logic element, a control terminal of the multiplexer of the first carry logic may be coupled to a first logic gate in the first LUT.

Some such configurable logic element may further include: a carry chain multiplexer coupled to at least one of the first LUT or the second LUT, a control interface of the carry chain multiplexer coupled to at least one of the first logic gate or the second logic gate.

In some such configurable logic element, control terminals of the first and second cascade multiplexers may be coupled to configurable memory cells in the programmable IC.

In another example, a programmable integrated circuit (IC) may be provided. Such a programmable IC may include: a configuration memory; and a plurality of configurable logic elements coupled to the configuration memory, each of the plurality of configurable logic elements comprising: a first lookup-table (LUT) including first inputs and first outputs, and first sum logic and first carry logic coupled between the first inputs and the first outputs; a second LUT including second inputs and second outputs, and second sum logic coupled between the second inputs and the second outputs; and first and second cascade multiplexers respectively coupled to the first and second LUTs, an input of the second cascade multiplexer coupled to an output of the first carry logic in the first LUT.

The programmable IC may further include a carry chain multiplexer coupled to at least one of the first LUT or the second LUT.

In some such programmable IC, the second LUT may include second carry chain logic, and wherein an input of the carry chain multiplexer may be coupled to an output of the second carry logic in the second LUT.

Some such programmable IC may further include a carry input coupled to the first cascade multiplexer.

In some such programmable IC, the carry input may be further coupled to an input of the carry chain multiplexer.

In some such programmable IC, an input of the carry chain multiplexer may be coupled to an output of the first cascade multiplexer.

In some such programmable IC, each of the first and second sum logic may include an exclusive OR gate, and the first carry logic may include a multiplexer.

In some such programmable IC, a control terminal of the multiplexer of the first carry logic may be coupled to a first logic gate in the first LUT.

In some such programmable IC, control terminals of the first and second cascade multiplexers may be coupled to configurable memory cells in the programmable IC.

In another example a method of configuration a programmable IC may be provided. Such a method may include: configuring a first lookup-table (LUT) in a configurable logic element to compute a first sum, the first LUT including first inputs and first outputs, and first sum logic and first carry logic coupled between the first inputs and the first outputs; configuring a second LUT in the configurable logic element to compute a second sum, the second LUT including second inputs and second outputs, and second sum logic coupled between the second inputs and the second outputs; and configuring a cascade multiplexer to couple an output of the first carry logic in the first LUT to an input of the second sum logic in the second LUT.

In another example, a LUT for a programmable integrated circuit (IC) includes a plurality of input terminals, and a cascading input coupled to at least one other LUT in the programmable IC. The LUT further includes LUT logic having a plurality of LUTs each coupled to a common set of the input terminals. The LUT further includes a plurality of multiplexers having inputs coupled to outputs of the plurality of LUTs, and an output multiplexer having inputs coupled to outputs of the plurality of multiplexers. The LUT further includes a plurality of cascading multiplexers each having an output coupled to a control input of a respective one of the plurality of multiplexers, each of the plurality of cascading multiplexers comprising a plurality of inputs, at least one of the plurality of inputs coupled to the cascading input.

In another example, a look-up table (LUT) for a programmable integrated circuit (IC) may be provided. Such a LUT may include: a plurality of input terminals; a cascading input coupled to at least one other LUT in the programmable IC; LUT logic having a plurality of LUTs each coupled to a common set of the input terminals; a plurality of multiplexers having inputs coupled to outputs of the plurality of LUTs; an output multiplexer having inputs coupled to outputs of the plurality of multiplexers; and a plurality of cascading multiplexers each having an output coupled to a control input of a respective one of the plurality of multiplexers, each of the plurality of cascading multiplexers comprising a plurality of inputs, at least one of the plurality of inputs coupled to the cascading input.

In some such LUT, the plurality of LUTs comprise at least four LUTs; the plurality of multiplexers comprise at least two multiplexers coupled to the at least four LUTs; and the plurality of cascading multiplexers comprise at least two cascading multiplexers coupled to control the at least two multiplexers.

In some such LUT, each of the at least four LUTs may include a 4-input LUT; the plurality of input terminals comprises four inputs coupled to each of the 4-input LUTs.

In some such LUT, at least one of the plurality of inputs of each of the plurality of cascading multiplexers may be coupled to at least one of the plurality of input terminals.

In some such LUT, the cascading input may include a bus having a plurality of signals.

In some such LUT, control inputs of the plurality of cascading multiplexers may be coupled to memory in the programmable IC.

In some such LUT, the memory may include configuration memory of the programmable IC.

In some such LUT, a control input of the output multiplexer may be coupled to a terminal of the plurality of input terminals.

Some such LUT, may further include a plurality of output terminals coupled to the outputs of the plurality of multiplexers and the output multiplexer.

In another example, a programmable IC may be provided. Such a programmable IC may include: a configuration memory; and at least one configurable logic element (CLE), coupled to the configuration memory, having a plurality of look-up tables (LUTs), each of the plurality of LUTs including an output terminal and a cascading input; wherein a cascading input of a first LUT of the plurality of LUTs is coupled to the output terminal of a second LUT of the plurality of LUTs.

In some such programmable IC, each of the plurality of LUTs further include: a plurality of input terminals; LUT logic having a plurality of LUTs each coupled to a common set of the input terminals; a plurality of multiplexers having inputs coupled to outputs of the plurality of LUTs; an output multiplexer having inputs coupled to outputs of the plurality of multiplexers and an output coupled to the output terminal; and a plurality of cascading multiplexers each having an output coupled to a control input of a respective one of the plurality of multiplexers, each of the plurality of cascading multiplexers comprising a plurality of inputs, at least one of the plurality of inputs coupled to the cascading input.

In some such programmable IC, for each of the plurality of LUTs, at least one of the plurality of inputs of each of the plurality of cascading multiplexers may be coupled to at least one of the plurality of input terminals.

In some such programmable IC, for each of the plurality of LUTs, the cascading input may include a bus having a plurality of signals.

In some such programmable IC, for each of the plurality of LUTs, control inputs of the plurality of cascading multiplexers may be coupled to memory in the programmable IC.

In some such programmable IC, the memory may include the configuration memory.

In some such programmable IC, for each of the plurality of LUTs, a control input of the output multiplexer may be coupled to a terminal of the plurality of input terminals.

In some such programmable IC, the first LUT and the second LUT are configured to implement a combinatorial function.

In some such programmable IC, the first LUT and the second LUT may be configured to implement a multiplexer.

In another example, a method of operating a LUT in a programmable IC may be provided. Such a method of operating a LUT may include: coupling a common set of input signals to a plurality of LUTs in LUT logic; coupling a cascade input to each of a plurality of cascading multiplexers, the cascade input coupled to at least one other LUT in the programmable IC; controlling at least one of the plurality of cascading multiplexers to select a signal of the cascade input; and coupling output of the cascading multiplexers to multiplexer logic operable to select among outputs of the plurality of LUTs in the LUT logic.

In some such method, the operation of controlling may include: controlling a first cascading multiplexer of the plurality of multiplexers to select a first signal of the cascade input; and controlling a second cascading multiplexer of the plurality of multiplexers to select a second signal of the cascade input different than the first signal.

While the foregoing is directed to specific examples, other and further examples may be devised without departing from the basic scope thereof, and the scope thereof is determined by the claims that follow.

## Claims

1. A configurable logic element (112) for a programmable integrated circuit (IC) (100), comprising:
a first lookup-table (LUT) (302-0) including first inputs and first outputs, and first sum logic (312-0) and first carry logic (310-0) coupled between the first inputs and the first outputs;
a second LUT (302-1) including second inputs and second outputs, and second sum logic (312-1) coupled between the second inputs and the second outputs; and
a first cascade multiplexer (322-0) coupled to one of the first inputs of the first LUT and a second cascade multiplexer (322-1) coupled to one of the second inputs of the second LUT (302-1), an input of the second cascade multiplexer (322-1) coupled to an output of the first carry logic (310-0) in the first LUT.

2. The configurable logic element (112) of claim 1, further comprising:
a carry chain multiplexer (314) coupled to at least one of the first LUT or the second LUT (302-1).

3. The configurable logic element (112) of claim 2, wherein the second LUT (302-1) includes second carry logic (310-1), and wherein an input of the carry chain multiplexer (314) is coupled to an output of the second carry logic in the second LUT (302-1).

4. The configurable logic element (112) of claim 2, further comprising:
a carry input coupled to the first cascade multiplexer (322-0).

5. The configurable logic element (112) of claim 4, wherein the carry input is further coupled to an input of the carry chain multiplexer (314).

6. The configurable logic element (112) of claim 2, wherein an input of the carry chain multiplexer (314) is coupled to an output of the first cascade multiplexer (322-0).

7. The configurable logic element (112) of claim 1, wherein each of the first and second sum logic (312-0, 312-1) comprises an exclusive OR gate (320, 308), and wherein the first carry logic (310-0) comprises a multiplexer (318).

8. The configurable logic element (112) of claim 7, wherein a control terminal of the multiplexer of the first carry logic (310-0) is coupled to a first logic gate (304-0) in the first LUT.

9. The configurable logic element (112) of claim 8, further comprising:
a carry chain multiplexer (314) coupled to at least one of the first LUT or the second LUT (302-1), a control interface of the carry chain multiplexer (314) coupled to at least one of the first logic gate or the second logic gate.

10. The configurable logic element (112) of claim 1, wherein control terminals of the first and second cascade multiplexers (322-0, 322-1) are coupled to configurable memory cells in the programmable IC.

11. A method of configuring a programmable integrated circuit (IC) (100), comprising:
configuring a first lookup-table (LUT) (302-0) in a configurable logic element (112) to compute a first sum, the first LUT including first inputs and first outputs, and first sum logic (312-0) and first carry logic (310-0) coupled between the first inputs and the first outputs;
configuring a second LUT (302-1) in the configurable logic element (112) to compute a second sum, the second LUT (302-1) including second inputs and second outputs, and second sum logic (312-1) coupled between the second inputs and the second outputs; and
configuring a cascade multiplexer (322-0) to couple an output of the first carry logic (310-0) in the first LUT to an input of the second sum logic (312-1) in the second LUT.

## Patentansprüche

1. Konfigurierbares Logikelement (112) für eine programmierbare integrierte Schaltung (IC) (100), umfassend:
eine erste Nachschlagetabelle (LUT) (302-0), enthaltend erste Eingänge und erste Ausgänge und eine erste Summenlogik (312-0) und erste Übertragslogik (310-0), gekoppelt zwischen den ersten Eingängen und den ersten Ausgängen;
eine zweite LUT (302-1), enthaltend zweite Eingänge und zweite Ausgänge und eine zweite Summenlogik (312-1) gekoppelt zwischen den zweiten Eingängen und den zweiten Ausgängen; und
einen ersten Kaskadenmultiplexer (322-0), gekoppelt an einen der ersten Eingänge der ersten LUT, und einen zweiten Kaskadenmultiplexer (322-1), gekoppelt an einen der zweiten Eingänge der zweiten LUT (302-1), wobei ein Eingang des zweiten Kaskadenmultiplexers (322-1) an einen Ausgang der ersten Übertragslogik (310-0) in der ersten LUT gekoppelt ist.

2. Konfigurierbares Logikelement (112) nach Anspruch 1, ferner umfassend:
einen Übertragskettenmultiplexer (314), gekoppelt an mindestens eine der ersten LUT oder der zweiten LUT (302-1).

3. Konfigurierbares Logikelement (112) nach Anspruch 2, wobei die zweite LUT (302-1) eine zweite Übertragslogik (310-1) enthält und wobei ein Eingang des Übertragskettenmultiplexers (314) an einen Ausgang der zweiten Übertragslogik in der zweiten LUT (302-1) gekoppelt ist.

4. Konfigurierbares Logikelement (112) nach Anspruch 2, ferner umfassend:
einen Übertragseingang, gekoppelt an den ersten Kaskadenmultiplexer (322-0).

5. Konfigurierbares Logikelement (112) nach Anspruch 4, wobei der Übertragseingang ferner an einen Eingang des Übertragskettenmultiplexers (314) gekoppelt ist.

6. Konfigurierbares Logikelement (112) nach Anspruch 2, wobei ein Eingang des Übertragskettenmultiplexers (314) an einen Ausgang des ersten Kaskadenmultiplexers (322-0) gekoppelt ist.

7. Konfigurierbares Logikelement (112) nach Anspruch 1, wobei jede der ersten und der zweiten Summenlogik (312-0, 312-1) ein exklusives ODER-Gatter (320, 308) umfasst und wobei die erste Übertragslogik (310-0) einen Multiplexer (318) umfasst.

8. Konfigurierbares Logikelement (112) nach Anspruch 7, wobei ein Steueranschluss des Multiplexers der ersten Übertragslogik (310-0) an ein erstes Logikgatter (304-0) in der ersten LUT gekoppelt ist.

9. Konfigurierbares Logikelement (112) nach Anspruch 8, ferner umfassend:
einen Übertragskettenmultiplexer (314), gekoppelt an mindestens eine der ersten LUT oder der zweiten LUT (302-1), eine Steuerschnittstelle des Übertragskettenmultiplexers (314), gekoppelt an mindestens eines des ersten Logikgatters oder des zweiten Logikgatters.

10. Konfigurierbares Logikelement (112) nach Anspruch 1, wobei Steueranschlüsse des ersten und des zweiten Kaskadenmultiplexers (322-0, 322-1) an konfigurierbare Speicherzellen in der programmierbaren IC gekoppelt sind.

11. Verfahren zum Konfigurieren einer programmierbaren integrierten Schaltung (IC) (100), umfassend:
Konfigurieren einer ersten Nachschlagetabelle (LUT) (302-0) in einem konfigurierbaren Logikelement (112), um eine erste Summe zu berechnen, die erste LUT enthaltend erste Eingänge und erste Ausgänge und eine erste Summenlogik (312-0) und erste Übertragslogik (310-0), gekoppelt zwischen den ersten Eingängen und den ersten Ausgängen;
Konfigurieren einer zweiten LUT (302-1) in dem konfigurierbaren Logikelement (112), um eine zweite Summe zu berechnen, die zweite LUT (302-1) enthaltend zweite Eingänge und zweite Ausgänge und eine zweite Summenlogik (312-1) gekoppelt zwischen den zweiten Eingängen und den zweiten Ausgängen; und
Konfigurieren eines Kaskadenmultiplexers (332-0), einen Ausgang der ersten Übertragslogik (310-0) in der ersten LUT an einen Eingang der zweiten Summenlogik (312-1) in der zweiten LUT zu koppeln.

## Revendications

1. Élément logique configurable (112) pour un circuit intégré (IC) programmable (100), comprenant :
une première table de consultation (LUT) (302-0) qui inclut des premières entrées et des premières sorties, et une première logique de somme (312-0) et une première logique de report (310-0) qui sont couplées entre les premières entrées et les premières sorties ;
une seconde LUT (302-1) qui inclut des secondes entrées et des secondes sorties, et une seconde logique de somme (312-1) qui est couplée entre les secondes entrées et les secondes sorties ; et
un premier multiplexeur en cascade (322-0) qui est couplé à l'une des premières entrées de la première LUT et un second multiplexeur en cascade (322-1) qui est couplé à l'une des secondes entrées de la seconde LUT (302-1), une entrée du second multiplexeur en cascade (322-1) étant couplée à une sortie de la première logique de report (310-0) dans la première LUT.

2. Élément logique configurable (112) selon la revendication 1, comprenant en outre :
un multiplexeur de chaîne de report (314) qui est couplé à au moins l'une de la première LUT et de la seconde LUT (302-1).

3. Élément logique configurable (112) selon la revendication 2, dans lequel la seconde LUT (302-1) inclut une seconde logique de report (310-1), et dans lequel une entrée du multiplexeur de chaîne de report (314) est couplée à une sortie de la seconde logique de report dans la seconde LUT (302-1).

4. Élément logique configurable (112) selon la revendication 2, comprenant en outre :
une entrée de report qui est couplée au premier multiplexeur en cascade (322-0).

5. Élément logique configurable (112) selon la revendication 4, dans lequel l'entrée de report est en outre couplée à une entrée du multiplexeur de chaîne de report (314).

6. Élément logique configurable (112) selon la revendication 2, dans lequel une entrée du multiplexeur de chaîne de report (314) est couplée à une sortie du premier multiplexeur en cascade (322-0).

7. Élément logique configurable (112) selon la revendication 1, dans lequel chacune des première et seconde logiques de somme (312-0, 312-1) comprend une porte OU-Exclusif (320, 308), et dans lequel la première logique de report (310-0) comprend un multiplexeur (318).

8. Élément logique configurable (112) selon la revendication 7, dans lequel une borne de commande du multiplexeur de la première logique de report (310-0) est couplée à une première porte logique (304-0) dans la première LUT.

9. Élément logique configurable (112) selon la revendication 8, comprenant en outre :
un multiplexeur de chaîne de report (314) qui est couplé à au moins l'une de la première LUT et de la seconde LUT (302-1), une interface de commande du multiplexeur de chaîne de report (314) étant couplée à au moins l'une de la première porte logique ou de la seconde porte logique.

10. Élément logique configurable (112) selon la revendication 1, dans lequel des bornes de commande des premier et second multiplexeurs en cascade (322-0, 322-1) sont couplées à des cellules de mémoire configurables à l'intérieur de l'IC programmable.

11. Procédé de configuration d'un circuit intégré (IC) programmable (100), comprenant :
la configuration d'une première table de consultation (LUT) (302-0) dans un élément logique configurable (112) de manière à calculer une première somme, la première LUT incluant des premières entrées et des premières sorties, et une première logique de somme (312-0) et une première logique de report (310-0) qui sont couplées entre les premières entrées et les premières sorties ;
la configuration d'une seconde LUT (302-1) dans l'élément logique configurable (112) de manière à calculer une seconde somme, la seconde LUT (302-1) incluant des secondes entrées et des secondes sorties, et une seconde logique de somme (312-1) qui est couplée entre les secondes entrées et les secondes sorties ; et
la configuration d'un multiplexeur en cascade (322-0) de manière à coupler une sortie de la première logique de report (310-0) dans la première LUT à une entrée de la seconde logique de somme (312-1) dans la seconde LUT.
